# EUROPÄISCHE PATENTSCHRIFT

(11) **EP 2 680 043 B1**
(45) Veröffentlichungstag und Bekanntmachung des Hinweises auf die Patenterteilung: **11.11.2020**
(21) Anmeldenummer: 13002936.6
(22) Anmeldetag: 07.06.2013
(51) Int. Cl.: G01V 3/08

(54) **Kapazitiver Sensor für eine Kollisionsschutzvorrichtung**
Capacitive sensor for an anti-collision device
Capteur capacitif pour dispositif de protection contre la collision

(30) Priorität: 28.06.2012 DE 102012012864
(43) Veröffentlichungstag der Anmeldung: 01.01.2014
(73) Patentinhaber: Brose Fahrzeugteile SE & Co. Kommanditgesellschaft, Bamberg, 96052 Bamberg (DE)
(72) Erfinder: Würstlein, Holger, 97475 Zeil am Main (DE); Pohl, Florian, 96237 Ebersdorf (DE)
(74) Vertreter: FDST Patentanwälte

(56) Entgegenhaltungen:
- EP-A1- 2 369 742
- DE-A1-102007 026 307
- DE-A1-102008 028 932
- DE-B3-102010 020 348
- US-A- 5 134 379

## Beschreibung

Die Erfindung bezieht sich auf einen kapazitiven Sensor zur Detektion eines Objekts, insbesondere eines Körperteils einer Person oder eines Gegenstandes sowie auf eine Kollisionsschutzvorrichtung mit einem solchen Sensor.

Kapazitive Sensoren werden in der Fahrzeugtechnik insbesondere im Rahmen einer Köllisionsschutzvorrichtung eingesetzt. Eine solche Kollisionsschutzvorrichtung dient allgemein zur Detektion eines Hindernisses in einem Öffnungsbereich eines Fahrzeugteils, das gegenüber einem festen Rahmen zwischen einer Öffnungsstellung und einer Schließstellung beweglich ist. Bei dem - nachfolgend auch als "Verstellelement" bezeichneten - Fahrzeugteil handelt es sich insbesondere um eine Fensterscheibe oder eine Heckklappe. Ferner kann das zu überwachende Fahrzeugteil bzw. Verstellelement auch eine Seitentür, eine Kofferraum- oder Motorraumklappe, ein Schiebedach oder ein Klappverdeck sein. Kollisionsschutzvorrichtungen werden dabei insbesondere dann eingesetzt, wenn das jeweils zugeordnete Fahrzeugteil motorisch bewegt ist.

Als Öffnungsbereich wird der Raum bezeichnet, den das Verstellelement während einer Verstellbewegung durchstreift. Zu dem Öffnungsbereich des Verstellelements gehört insbesondere der Raumbereich, der zwischen einer Schließkante des Verstellelements und einer in der Schließstellung des Verstellelements an dieser anliegenden korrespondierenden Kante des Rahmens angeordnet ist.

Beim Schließen von Verstellelementen eines Fahrzeugs, insbesondere einer Fahrzeugscheibe oder Heckklappe, besteht generell die Gefahr, dass Körperteile oder sonstige Gegenstände des Verstellelements zwischen der Schließkante des Verstellelements und der Karosserie eingeklemmt werden. Die in diesem Anwendungsfall auch als Einklemmschutzvorrichtung bezeichnete Kollisionsschutzvorrichtung dient zur Vermeidung eines solchen Einklemmfalls und der daraus resultierenden Gefahr eines Personen- und/oder Sachschadens, indem die Kollisionsschutzvorrichtung Hindernisse im Öffnungsbereich erkennt und in diesem Fall die Schließbewegung stoppt oder reversiert.

Eine solche Kollisionsschutzvorrichtung kann des Weiteren - bei ausschwenkenden Verstellelementen - auch eingesetzt werden, um Hindernisse zu erkennen, die der Öffnung des Verstellelements im Wege stehen. Auch in diesem Anwendungsfall stoppt oder reversiert die Kollisionsschutzvorrichtung die Bewegung des Verstellelements, wenn sie ein solches Hindernis erkennt, um einen Sachschaden infolge einer Kollision des Verstellelements mit dem Hindernis zu vermeiden.

Es wird hierbei zwischen indirekten und direkten Kollisionsschutzvorrichtungen unterschieden. Eine indirekte Kollisionsschutzvorrichtung erkennt den Einklemm- oder Kollisionsfall anhand einer Überwachung einer Betriebsgröße des das Verstellelement antreibenden Stellmotors, insbesondere an einem abnormalen Anstieg des Motorstroms oder einer abnormalen Abnahme der Motordrehzahl. Eine direkte Kollisionsschutzvorrichtung umfasst üblicherweise einen oder mehrere Sensoren, die eine für die Anwesenheit bzw. Abwesenheit eines Hindernisses im Öffnungsbereich charakteristische Messgröße erfassen, sowie eine Auswerteeinheit, die anhand dieser Messgröße entscheidet, ob ein Hindernis im Öffnungsbereich vorliegt und gegebenenfalls entsprechende Gegenmaßnahmen auslöst. Unter den direkten Kollisionsschutzvorrichtungen unterscheidet man wiederum Systeme mit so genannten Berührungssensoren, die die Anwesenheit eines Hindernisses erst anzeigen, wenn das Hindernis den Sensor bereits berührt, und Systeme mit berührungslosen Sensoren, die ein Hindernis bereits in einem gewissen Abstand zu dem Sensor detektieren. Zu den berührungslosen Sensoren gehören insbesondere so genannte kapazitive (Näherungs-) Sensoren.

Ein kapazitiver Sensor umfasst üblicherweise eine Elektrodenanordnung mit einer oder mehreren (Sensor-)Elektroden, über die ein elektrisches Feld im Öffnungsbereich des Verstellelements aufgebaut wird. Ein Hindernis im Öffnungsbereich wird durch Überwachung der Kapazität der Elektrodenanordnung erkannt. Hierbei wird ausgenutzt, dass ein Hindernis, insbesondere ein menschliches Körperteil das von dem Sensor erzeugte elektrische Feld und somit die Kapazität der Elektrodenanordnung beeinflusst.

In einer üblichen Bauform eines solchen kapazitiven Sensors umfasst die Elektrodenanordnung dieses Sensors als Sensorelektroden mindestens eine Sendeelektrode, die mit einem Signalerzeugungsschaltkreis zur Erzeugung eines Sendesignals verschaltet ist, sowie eine Empfangselektrode, die mit einem Auswerteschaltkreis zur Verarbeitung eines in der Empfangselektrode erzeugten Empfangssignals verbunden ist (Sender-Empfänger-Prinzip). Ein solcher Sensor misst die zwischen der Sendeelektrode und der Empfangselektrode gebildete Kapazität oder eine damit korrelierende Messgröße.

In einer alternativen Bauform umfasst die Elektrodenanordnung eines kapazitiven Sensors nur eine Sensorelektrode oder mehrere gleichartige Sensorelektroden, die mit dem Sendesignal beaufschlagt werden, und über die auch das kapazitätsabhängige Empfangs- oder Antwortsignal, z.B. in Form des Verschiebestroms, erfasst wird (Ein-Elektroden-Prinzip). Bei einem solchen Sensor wird als Gegenelektrode ein sensorexterner, auf Massepotential liegender Gegenstand herangezogen, insbesondere die Karosserie des Fahrzeugs, in dem der Sensor eingebaut ist. Bei einem solchen Sensor wird somit als Messgröße die Kapazität der Sensorelektrode(n) gegen Masse erfasst.

Als Sendesignal wird meist ein elektrisches Wechselsignal herangezogen, das mit einer vorgegebenen Sendefrequenz oszilliert. Der Auswerteschaltkreis ist zur Messung des in der Sensorelektrode (insbesondere Empfangselektrode) induzierten Verschiebestroms häufig niederohmig ausgeführt. In diesem Fall umfasst der Auswerteschaltkreis oft einen Tranzimpendanzverstärker. Ein solcher kapazitiver Sensor ist beispielsweise aus DE 10 2007 001 712 A1 bekannt.

Bei einer Kollisionsschutzvorrichtung mit einem kapazitiven Sensor kann es zu Detektionsfehlern kommen, wenn die Sendefrequenz gestört ist, d.h. wenn die Sensorelektrode (insbesondere die Empfangselektrode) mit einem externen Wechselfeld beaufschlagt wird, dessen Frequenz gleich oder ähnlich zu der Sendefrequenz des Sensors ist. Ein solcher Detektionsfehler kann einerseits darin resultieren, dass die Kollisionsschutzvorrichtung fälschlicherweise einen Einklemmfall detektiert und die Bewegung des Verstellelements - objektiv grundlos - stoppt oder reversiert. Ein solcher Detektionsfehler kann andererseits aber auch darin resultieren, dass ein tatsächlich vorliegender Einklemmfall durch die Kollisionsschutzvorrichtung nicht erkannt wird.

Zur Vermeidung solcher Störungen ist es mitunter gewünscht, die Frequenz des Sendesignals zu wechseln, um auf eine ungestörte Frequenz ausweichen zu können. Bei kapazitiven Sensoren, dessen Auswerteschaltkreis durch einen gewöhnlichen Transimpedanzverstärker mit ohmscher Gegenkopplung gebildet ist, wird ein Frequenzwechsel aber dadurch erschwert, dass die Impedanz des mit einem solchen Transimpedanzverstärker ausgestatteten Sensors eine ausgeprägte Frequenzabhängigkeit aufweist. Bei dem aus DE 10 2007 001 712 A1 bekannten Sensor ist diese (auch als Frequenzgang bezeichnete) Frequenzabhängigkeit sogar noch verstärkt dadurch, dass der dortige Transimpedanzverstärker nicht durch einen ohmschen Widerstand, sondern durch einen Parallelschwingkreis mit einer Kapazität und einer hierzu parallelgeschalteten Induktivität gegengekoppelt ist. Ein solcher Sensor weist eine hohe Frequenzselektivität auf. Er ist somit störunempfindlich für Störungen mit geringen Frequenzanteilen bei der Sendefrequenz. Ein solcher Sensor reagiert aber umso empfindlicher, wenn gerade die Sendefrequenz erheblich gestört ist. Ein ähnlicher Sensor ist aus DE 10 2007 026 307 A1 bekannt.

Ein kapazitiver Sensor nach dem Oberbegriff des Anspruchs 1 ist aus US 5,134,379 A bekannt. Dort ist der Transimpedanzverstärker in einer Ausführungsform durch eine Parallelschaltung eines Kondensators und eines Widerstands gegengekoppelt.

Aus DE 10 2008 028 932 A1 ist ein kapazitiver Sensor bekannt, bei dem als Auswerteschaltkreis ein Transimpedanzverstärker mit Bandpass vorgesehen ist.

Der Erfindung liegt die Aufgabe zugrunde, einen störunanfälligen kapazitiven Sensor zur Detektion eines Objekts sowie eine zugehörige Kollisionsschutzvorrichtung, insbesondere zur Detektion und Vermeidung eines Einklemmfalls oder einer sonstigen Kollision eines beweglichen Fahrzeugteils mit einem Objekt anzugeben.

Bezüglich des kapazitiven Sensors wird diese Aufgabe erfindungsgemäß gelöst durch die Merkmale des Anspruchs 1. Bezüglich der Kollisionsschutzvorrichtung wird diese Aufgabe erfindungsgemäß gelöst durch die Merkmale des Anspruchs 4. Vorteilhafte Ausgestaltungen und Weiterbildungen der Erfindung sind Gegenstand der Unteransprüche oder ergeben sich aus der nachfolgenden Beschreibung.

Der erfindungsgemäße Sensor umfasst eine Elektrodenanordnung, die mindestens eine Sensorelektrode umfasst. Der Sensor umfasst außerdem einen Auswerteschaltkreis, der der mindestens einen Sensorelektrode nachgeschaltet ist. Der Auswerteschaltkreis dient zur Verarbeitung eines Empfangssignals (oder Antwortsignals), das unter Wirkung eines mittels der Elektrodenanordnung emittierten elektrischen Felds in der Sensorelektrode erzeugt wird.

Der Auswerteschaltkreis weist hierbei erfindungsgemäß eine niederohmige Eingangsschaltung auf, die durch einen Transimpedanzverstärker gebildet ist. Im Unterschied zu einem gewöhnlichen Transimpedanzverstärker weist der Transimpedanzverstärker gemäß der Erfindung Mittel zur Frequenzgangkompensation auf, also Mittel, die die Frequenzabhängigkeit des mit dem Transimpedanzverstärker ausgestatteten Sensors zumindest in einem vorgegebenen Frequenzbereich eliminieren.

Die Erfindung kann grundsätzlich auf nach dem Ein-Elektroden-Prinzip arbeitende kapazitive Sensoren angewendet werden, die die Kapazität ihrer Sensorelektrode(n) gegen Masse sensieren. Vorzugsweise handelt es sich bei dem Sensor aber um einen kapazitiven Sensor, der nach dem Sender-Empfänger-Prinzip arbeitet. Entsprechend umfasst die Elektrodenanordnung bevorzugt als Sensorelektroden mindestens eine Sendeelektrode und mindestens eine Empfangselektrode. Der - in diesem Fall auch als Empfangsschaltkreis bezeichnete - Auswerteschaltkreis ist hier der mindestens einen Empfangselektrode nachgeschaltet und erhält als Eingangsgröße das Empfangssignal, das in der Empfangselektrode unter Wirkung des von der mindestens einen Sendeelektrode emittierten elektrischen Feldes erzeugt wird.

Wie ein gewöhnlicher Transimpedanzverstärker weist der erfindungsgemäße Transimpedanzverstärker als zentrales Bauteil vorzugsweise einen Operationsverstärker auf, dessen nicht-invertierender Eingang auf Masse geschaltet ist, und dessen invertierender Eingang unmittelbar oder mittelbar mit der Empfangselektrode verschaltet ist.

Im Unterschied zu einem gewöhnlichen Transimpedanzverstärker ist der Ausgang des Operationsverstärkers allerdings als Mittel zur Frequenzgangkompensation nicht über einen ohmschen Widerstand, sondern über eine Parallelschaltung einer Koppelkapazität und eines ohmschen Koppelwiderstandes gegengekoppelt. In dieser Ausführung hat der Transimpedanzverstärker ein Hochpassverhalten. Die Frequenzgangkompensation wirkt hier somit nur für hohe Frequenzen, während der Verstärkungsfaktor des Sensors für Frequenzen unterhalb einer unteren Grenzfrequenz mit sinkender Frequenz stark abnimmt. Die Beschaltung des Operationsverstärkers ist vorzugsweise derart ausgelegt, dass die untere Grenzfrequenz in Abhängigkeit von der gewünschten Betriebsfrequenz zwischen 1 kHz und 1 MHz, insbesondere bei etwa 100 kHz liegt.

Dem invertierenden Ausgang des Operationsverstärkers ist weiterhin eine Induktivität vorgeschaltet. Die Induktivität ist somit dem invertierenden Ausgang des Operationsverstärkers und der Empfangselektrode zwischengeschaltet. Somit hat der Transimpedanzverstärker ein Bandpassverhalten. Die Frequenzgangkompensation wirkt hier somit nur in einem vorgegebenen Frequenzbereich, während der Verstärkungsfaktor des Sensors sowohl für unterhalb der unteren Grenzfrequenz liegende Frequenzen als auch für Frequenzen oberhalb einer oberen Grenzfrequenz mit abnehmender bzw. zunehmender Frequenz stark abnimmt. Die Beschaltung des Operationsverstärkers ist vorzugsweise derart ausgelegt, dass die obere Grenzfrequenz in Abhängigkeit von der gewünschten Betriebsfrequenz zwischen 1 MHz und 100 MHz, insbesondere bei etwa 10 MHz liegt.

In einer zweckmäßigen Weiterbildung ist die Koppelkapazität hinsichtlich ihrer konstruktiven Ausgestaltung und/oder Materialzusammensetzung in gleicher oder ähnlicher Weise ausgebildet wie die Sensorelektrode(n). Zusätzlich oder alternativ ist die Koppelkapazität vorzugsweise darart angeordnet, dass sie den gleichen oder ähnlichen Betriebsbedingungen (z.B. Temperatur, Schmutz, Nässe, Betriebsalter, ...) ausgesetzt ist wie die Sensorelektrode(n). Durch diese Maßnahmen wird erreicht, dass die Koppelkapazität eine etwaige Kapazitätsdrift in Abhängigkeit der Temperatur, des Betriebsalters, etc. in gleicher oder ähnlicher Weise vollzieht wie die Elektrodenanordnung, so dass gegebenenfalls die Drift der Sensorelektrode(n) durch die Koppelkapazität ganz oder teilweise kompensiert wird.

Die erfindungsgemäße Kollisionsschutzvorrichtung umfasst einen kapazitiven Sensor der vorstehend beschriebenen Art.

Nachfolgend werden Ausführungsbeispiele der Erfindung anhand einer Zeichnung näher beschrieben. Darin zeigen:
- Fig. 1: in einem schematischen Blockschalbild eine Einklemmschutzvor-richtung zur Erkennung und Vermeidung eines Einklemmfalls bei einem beweglichen Fahrzeugteil, mit einem kapazitiven Sensor, der eine Sendeelektrode, eine Empfangselektrode, einen der Sende-elektrode vorgeschalteten Signalerzeugungsschaltkreis sowie einen der Empfangselektrode nachgeschalteten Empfangsschaltkreis um-fasst,
- Fig. 2: in einem vereinfachten elektrischen Schaltbild den Aufbau des Emp-fangsschaltkreises, der hier im Wesentlichen durch einen mittels ei-ner Kapazität gegengekoppelten Transimpedanzvertärker gebildet ist,
- Fig. 3: in einem Diagramm der Ausgangsspannung gegen die Frequenz eines Eingangssignals den Frequenzgang des mit dem Transimpedanzverstärker gemäß Fig. 2 ausgestatteten Sensors,
- Fig. 4: in Darstellung gemäß Fig. 2 eine Variante des dortigen Transimpedanzvertärkers, der hier über eine Kapazität mit parallel-geschaltetem ohmschen Widerstand gegengekoppelt ist,
- Fig. 5: in Darstellung gemäß Fig. 3 den frequenzgang des mit dem Transimpedanzvertärker gemäß Fig. 4 ausgestatteten Sensors,
- Fig. 6: in Darstellung gemäß Fig. 4 eine Weiterentwicklung des dortigen Transimpedanzvertärker, der hier eingangsseitig mit einer zusätz-lichen Induktivität beschaltet ist, und
- Fig. 7: in Darstellung gemäß Fig. 5 den Frequenzgang des mit dem Transimpedanzverstärker gemäß Fig. 6 ausgestattetenen Sensors.

Einander entsprechende Teile und Größen sind in allen Figuren stets mit gleichen Bezugszeichen versehen.

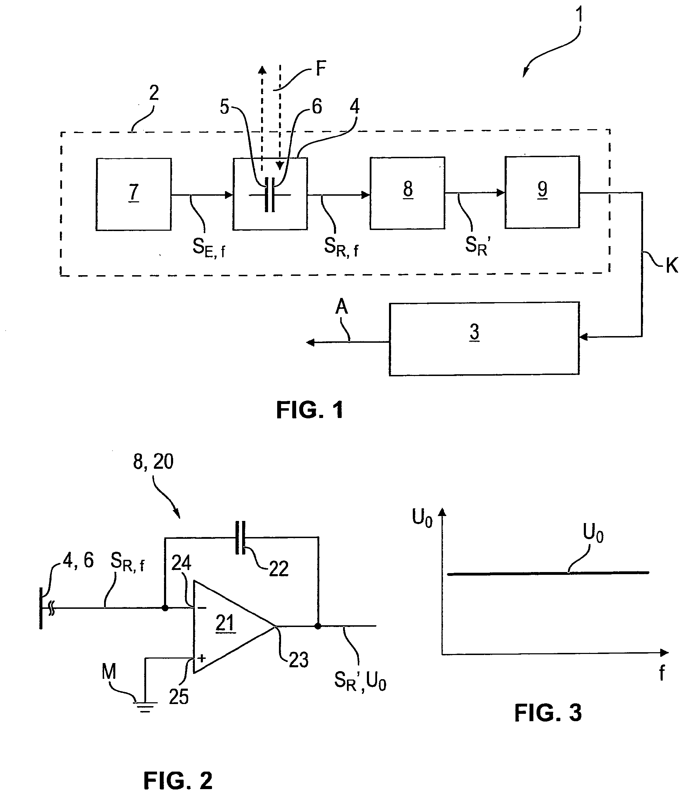

Fig. 1 zeigt in schematischer Darstellung eine Einklemmschutzvorrichtung 1 für ein (nicht näher dargestelltes) bewegliches Verstellelement eines Kraftfahrzeugs, insbesondere eine motorisch bewegte Tür oder Heckklappe. Die Einklemmschutzvorrichtung 1 umfasst einen kapazitiven Sensor 2 sowie eine Überwachungseinheit 3.

Der Sensor 2 basiert auf einer kapazitiven Messtechnik. Der Sensor 2 umfasst entsprechend eine Elektrodenanordnung 4 mit mindestens einer Sendeelektrode 5 sowie mindestens einer Gegenelektrode bzw. Empfangselektrode 6. Bevorzugt umfasst die Elektrodenanordnung 4 (in nicht näher dargestellter Weise) eine Mehrzahl von Sendeelektroden 5, die mit einer gemeinsamen Empfangselektrode 6 wechselwirken.

Im Betrieb des Sensors 2 wird durch Applikation einer elektrischen Wechselspannung auf die oder jede Sendeelektrode 5 ein (lediglich angedeutetes) elektrisches Feld F in einem Öffnungsbereich des Verstellelements erzeugt, während über die Empfangselektrode 6 die (elektrische) Kapazität des aus der feldemittierenden Sendeelektrode 5 und der Empfangselektrode 6 gebildeten Kondensators oder eine damit korrelierende Messgröße erfasst wird.

Im Einzelnen umfasst der Sensor 2 zusätzlich zu der Elektrodenanordnung 4 einen Signalerzeugungsschaltkreis 7, einen Empfangsschaltkreis 8 und ein Kapazitätsmessglied 9.

Im Betrieb des Sensors 2 erzeugt der Signalerzeugungsschaltkreis 7 ein Sendesignal S_{E} in Form einer sinusförmigen Wechselspannung oder eines Pulsspannungssignals einer vorgegebenen Frequenz f. Der Signalerzeugungsschaltkreis 7 gibt das Sendesignal S_{E} auf die Sendeelektrode 5, die unter Wirkung des Sendesignals S_{E} das elektrische Feld F emittiert. Sofern der Sensor 2 mehrere Sendeelektroden 5 umfasst, ist dem Signalerzeugungsschaltkreis 7 und der Elektrodenanordnung 4 vorzugsweise ein (nicht näher dargestellter) Zeitmultiplexer zwischengeschaltet, der das Sendesignal S_{E} zeitlich alternierend auf jeweils eine der mehreren Sendeelektroden 5 gibt.

Unter Wirkung des elektrischen Feldes F wird in der Empfangselektrode 6 ein elektrisches Wechselsignal erzeugt, das nachfolgend als Empfangssignal S_{R} bezeichnet ist. Das Empfangssignal S_{R} ist im störungsfreien Betrieb phasensynchron mit dem Sendesignal S_{E} und oszilliert somit mit der Frequenz f des Sendesignals S_{E}. Im Gegensatz zu dem Sendesignal S_{E} variiert die Signalamplitude des Empfangssignals S_{R} aber zusätzlich in Abhängigkeit von der zu messenden Kapazität.

Das Empfangssignal S_{R} ist dem Empfangsschaltkreis 8 als Eingangssignal zugeführt. Der Empfangselektrode 6 und dem Empfangsschaltkreis 8 ist hierbei optional ein (nicht explizit dargestellter) Tiefpass zur Vorfilterung des Empfangssignals S_{R} zwischengeschaltet. Der Empfangsschaltkreis 8 umfasst als wesentlichen Bestandteil einen Transimpedanzverstärker 20 (Fig. 2). Der Empfangsschaltkreis 8 gibt hierbei ein - nachfolgend als Empfangssignal S_{R}' bezeichnetes - Spannungssignal aus, das proportional zu dem unter Wirkung des Sendesignals S_{E} in der Empfangselektrode 6 induzierten Verschiebestrom ist. Dieses Empfangssignal S_{R}' wird dem der Empfangsschaltung 8 nachgeschalteten Kapazitätsmessglied 9 zugeführt, das hieraus eine kapazitätsproportionale Messgröße K erzeugt.

Die Messgröße K wird der dem Sensor 2 nachgeschalteten Überwachungseinheit 3 zugeführt. Die Überwachungseinheit 3, die vorzugsweise durch einen Mikrocontroller mit einer darin implementierten Überwachungssoftware gebildet ist, vergleicht die Messgröße K mit einem hinterlegten Auslöseschwellwert. Bei Schwellwertüberschreitung gibt die Überwachungseinheit 3 ein Auslösesignal A aus, das auf einen möglichen Einklemmfall hinweist, und unter dessen Wirkung die Bewegung des der Einklemmschutzvorrichtung 1 zugeordneten Verstellelements reversiert wird.

In einer nicht zu der Erfindung gehörenden Ausführung gemäß Fig. 2 ist der Transimpedanzverstärker 20 gebildet durch einen Operationsverstärker 21 und eine Koppelkapazität 22. Über die Koppelkapazität 22 ist der Ausgang 23 des Operationsverstärkers 22 mit dem invertierenden Eingang 24 gegengekoppelt. Über den invertierenden Eingang 24 ist der Operationsverstärker 21 unmittelbar- oder mittelbar über den gegebenenfalls vorhandenen Tiefpass - mit der Empfangselektrode 6 verschaltet. Der nicht-invertierende Eingang 25 des Operationsverstärkers 21 ist auf Masse M gelegt. Die Koppelkapazität 22 hat vorzugsweise einen Kapazitätswert von 10 pF.

Fig. 3 zeigt den Frequenzgang des mit dem Transimpedanzverstärker 20 gemäß Fig. 2 ausgestatteten Sensors 2, d.h. die Abhängigkeit einer Ausgabespannung U₀ des Transimpedanzverstärkers 20 von der Frequenz f des eingehenden Empfangssignals S_{R}, wobei von einer konstanten Signalamplitude des Sendesignals S_{E} ausgegangen wird. Die Ausgangsspannung U₀ bezeichnet hierbei die Amplitude des von dem Transimpedanzverstärker 20 ausgegebenen Empfangssignals S_{R}'. Wie Fig. 3 zu entnehmen ist, weist der mit dem Transimpedanzverstärker 20 gemäß Fig. 2 ausgestattete Sensor 2 aufgrund der ausschließlich kapazitiven Gegenkopplung einen verschwindenden, d.h. zu Null kompensierten Frequenzgang auf. Mit anderen Worten ist bei konstanter Signalamplitude des Sendesignals S_{E} die Ausgangsspannung U₀ für alle Frequenzen f zumindest näherungsweise gleich.

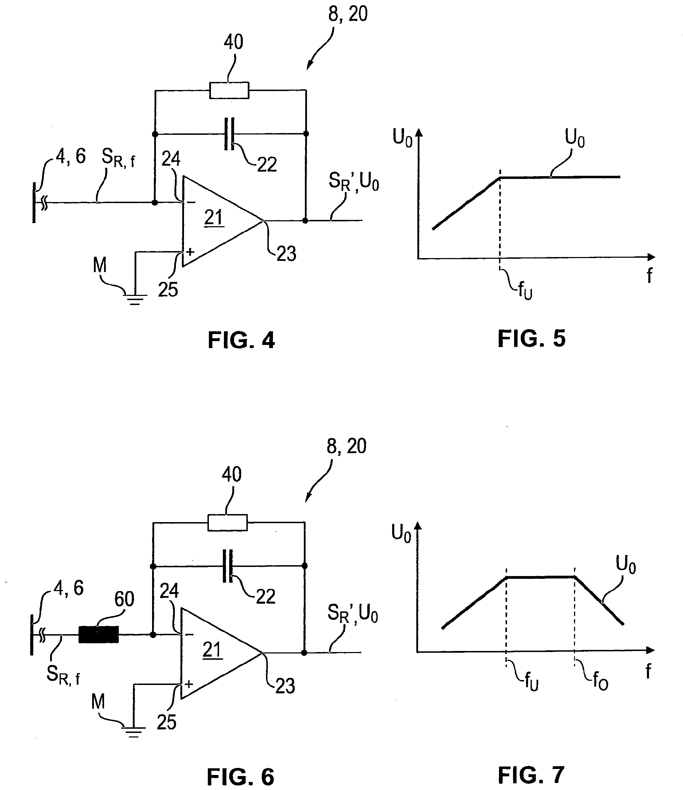

In Fig. 4 ist eine ebenfalls nicht zu der Erfindung gehörende Variante des Transimpedanzverstärkers 20 dargestellt. Diese unterscheidet sich von dem Ausführungsbeispiel gemäß Fig. 2 dadurch, dass der Koppelkapazität 22 ein Koppelwiderstand 40 parallel geschaltet ist. Die Koppelkapazität 22 hat vorzugsweise - wie im Beispiel gemäß Fig. 2 - einen Kapazitätswert von 10 pF. Der ohmsche Koppelwiderstand 40 hat vorzugsweise etwa einen Widerstandsbetrag von 1 MΩ.

Aus Fig. 5, die den Frequenzgang des mit dem Transimpedanzverstärker 20 gemäß Fig. 4 ausgestatteten Sensors 2 zeigt, ist erkennbar, dass der Transimpedanzverstärker 20 in der Ausführung gemäß Fig. 4 ein Hochpassverhalten zeigt. Mit anderen Worten ist der Frequenzgang des Sensors 2 nur für Frequenzen f des Empfangssignals S_{R} zu Null kompensiert, die eine untere Grenzfrequenz f_{U} überschreiten (f > f_{U}). Für Frequenzen f, die die untere Grenzfrequenz f_{U} unterscheiden (f < f_{U}), sinkt die Ausgabespannung U₀ - wiederum bei konstanter Signalstärke des Sendesignals S_{E} - dagegen mit abnehmender Frequenz f stark ab.

Eine erfindungsgemäße Variante des Transimpedanzverstärkers 20 ist in Fig. 6 dargestellt. Diese unterscheidet sich wiederum von der Ausführungsform gemäß Fig. 4 dadurch, dass dem invertierenden Eingang 24 des Operationsverstärkers 21 zusätzlich eine Induktivität 60 vorgeschaltet ist. Die Induktivität 60 ist somit dem Eingang 24 und der Empfangselektrode 6 zwischengeschaltet. Die Koppelkapazität 22 und der ohmsche Koppelwiderstand 40 haben vorzugsweise - wie im Beispiel gemäß Fig. 4 - einen Kapazitätswert von 10 pF bzw. einen einen Widerstandsbetrag von 1 MΩ. Die Induktivität 60 hat beispielsweise einen Induktivitätswert von 10 µH.

Aus Fig. 7, die den Frequenzgang des mit dem Transimpedanzverstärker 20 gemäß Fig. 6 ausgestatten Sensors 2 zeigt, ist erkennbar, dass der Sensor 2 hier ein Bandpassverhalten zeigt. Der Frequenzgang des Sensors 2 ist hier entsprechend nur in einem Frequenzbereich zu Null kompensiert, der zwischen der unteren Grenzfrequenz f_{U} und einer oberen Grenzfrequenz f_{O} liegt (f_{U} ≤ f ≤ f_{O}). Sowohl für Frequenzen f, die den unteren Grenzwert f_{U} unterschreiten (f < f_{U}) als auch für Frequenzen f, die den oberen Grenzwert f_{O} überschreiten (f > f_{O}) fällt die Ausgabespannung U₀ - wiederum bei konstanter Signalstärke des Sendesignals S_{E} - mit abnehmender bzw. zunehmender Frequenz f ab.

Obwohl vom Fachmann zahlreiche weitere Ausführungsformen abgeleitet werden können, wird die Erfindung nur durch die Ansprüche begrenzt.

### Bezugszeichenliste

- 1: Einklemmschutzvorrichtung
- 2: Sensor
- 3: Überwachungseinheit
- 4: Elektrodenanordnung
- 5: Sendeelektrode
- 6: Empfangselektrode
- 7: Signalerzeugungsschaltkreis
- 8: Empfangsschaltkreis
- 9: Kapazitätsmessglied
- 20: Transimpedanzverstärker
- 21: Operationsverstärker
- 22: Koppelkapazität
- 23: Ausgang
- 24: (invertierender) Eingang
- 25: (nicht-invertierender) Eingang
- 40: Koppelwiderstand
- 60: Induktivität

- A: Auslösesignal
- F: (elektrisches) Feld
- f: Frequenz
- f_{O}: (obere) Grenzfrequenz
- f_{U}: (untere) Grenzfrequenz
- K: Kapazitätsmessgröße
- M: Masse
- S_{E}: Sendesignal
- S_{R}: Empfangssignal
- S_{R}': Empfangssignal
- U₀: Ausgabespannung

## Patentansprüche

1. Kapazitiver Sensor (2) zur Detektion eines Objekts, insbesondere zur Detektion eines Kollisionsfalls bei einem beweglichen Fahrzeugteil, mit einer Elektrodenanordnung (4), die mindestens eine Sensorelektrode (6) umfasst, und mit einem der Sensorelektrode (6) nachgeschalteten Auswerteschaltkreis (8) zur Verarbeitung eines in der Sensorelektrode (6) erzeugten Empfangssignals (S_{R}), wobei der Auswerteschaltkreis (8) einen Transimpedanzverstärker (20) umfasst, der einen Operationsverstärker (21) aufweist, dessen nicht-invertierender Eingang (25) auf Masse (M) oder ein sonstiges Bezugspotential geschaltet ist, dessen invertierender Eingang (24) mit der Sensorelektrode (6) verschaltet ist, und dessen Ausgang (23) mit dem invertierenden Eingang (24) als Mittel zur Frequenzgangkompensation über eine Kapazität (22) mit parallel geschaltetem ohmschen Widerstand (40) gegengekoppelt ist,
**dadurch gekennzeichnet,**
**dass** dem invertierenden Eingang (24) des Operationsverstärkers (21) eine Induktivität (60) vorgeschaltet ist.

2. Sensor (2) nach Anspruch 1,
- wobei die Elektrodenanordnung (4) als Sensorelektroden mindestens eine Sendeelektrode (5) zur Emission eines elektrischen Feldes (F) unter Beaufschlagung mit einem Sendesignal (S_{E}) sowie mindestens eine Empfangselektrode (6) umfasst, und
- wobei der Auswerteschaltkreis (8) zur Verarbeitung des in der Empfangselektrode (6) unter Wirkung des elektrischen Feldes (F) erzeugten Empfangssignals (S_{R}) der Empfangselektrode (6) nachgeschaltet ist.

3. Sensor (2) nach Anspruch 1 oder 2,
wobei der Transimpedanzverstärker (20) einen Operationsverstärker (21) aufweist, dessen nicht-invertierender Eingang (25) auf Masse (M) oder ein sonstiges Bezugspotential geschaltet ist, dessen invertierender Eingang (24) mit der Sensorelektrode (6) verschaltet ist, und dessen Ausgang (23) mit dem invertierenden Eingang (24) als Mittel zur Frequenzgangkompensation ausschließlich über eine Kapazität (22) gegengekoppelt ist.

4. Kollisionsschutzvorrichtung (1) mit einem kapazitiven Sensor (2) nach einem der Ansprüche 1 bis 3.

## Claims

1. Capacitive sensor (2) for detecting an object, in particular for detecting a collision in a case of a moving vehicle part, with an electrode configuration (4), which comprises at least one sensor electrode (6), and with an evaluation circuit (8) for processing a reception signal (S_{R}) generated in the sensor electrode (6), said evaluation unit (8) being connected downstream of the sensor electrode (6), wherein the evaluation circuit (8) comprises a transimpedance amplifier (20), which has an operational amplifier (21) whose non-inverting input (25) is connected to ground (M) or another reference potential, whose inverting input (24) is connected to the sensor electrode (6), and whose output (23) is connected to the inverting input (24) as means for frequency response compensation via a capacitance (22) with a parallel-connected ohmic resistor (40),
**characterized in**
**that** an inductor (60) is connected upstream of the inverting input (24) of the operational amplifier (21).

2. Sensor (2) according to claim 1,
- wherein the electrode configuration (4) comprises as sensor electrodes at least one transmitting electrode (5) for the emission of an electric field (F) while being subjected to a transmission signal (S_{E}), and at least one reception electrode (6), and
- wherein the evaluation circuit (8) for processing the reception signal (S_{R}) generated in the reception electrode (6) under an action of the electric field (F) is connected downstream of the reception electrode (6).

3. Sensor (2) according to claim 1 or 2,
- wherein the transimpedance amplifier (20) comprises an operational amplifier, (21) whose non-inverting input (25) is connected to ground (M) or another reference potential, whose inverting input (24) is connected to the sensor electrode (6), and whose output (23) is connected to the inverting input (24) as a means of frequency response compensation exclusively via a capacitance (22).

4. Collision protection apparatus (1) with a capacitive sensor (2) according to one of claims 1 to 3.

## Revendications

1. Capteur capacitif (2) pour la détection d'un objet, en particulier pour la détection d'une collision dans le cas d'une partie mobile d'un véhicule, avec un ensemble d'électrodes (4), qui comprend au moins une électrode de capteur (6), et avec un circuit d'évaluation (8) pour le traitement d'un signal de réception (S_{R}) généré dans l'électrode de capteur (6), ledit circuit d'évaluation (8) étant monté en aval de l'électrode de capteur (6), dans lequel le circuit d'évaluation (8) comprend un amplificateur de transimpédance (20), qui comporte un amplificateur opérationnel (21), dont l'entrée non inverseuse (25) est connectée à la masse (M) ou à un autre potentiel de référence, dont l'entrée inverseuse (24) est connectée à l'électrode du capteur (6) et dont la sortie (23) est connectée à l'entrée inverseuse (24) comme moyen de compensation de la réponse en fréquence par l'intermédiaire d'une capacité (22) avec une résistance ohmique (40) montée en parallèle,
**caractérisé en ce**
**qu'**une inductance (60) est connectée en amont de l'entrée inverseuse (24) de l'amplificateur opérationnel (21).

2. Capteur (2) selon la revendication 1,
- dans lequel l'ensemble d'électrodes (4) comprend comme électrodes de capteur au moins une électrode d'émission (5) pour l'émission d'un champ électrique (F) en étant soumise à un signal d'émission (S_{E}), et au moins une électrode de réception (6), et
- dans lequel le circuit d'évaluation (8) pour le traitement du signal de réception (S_{R}) généré dans l'électrode de réception (6) sous l'action du champ électrique (F) est connecté en aval de l'électrode de réception (6).

3. Capteur (2) selon la revendication 1 ou 2,
- dans lequel l'amplificateur de transimpédance (20) comporte un amplificateur opérationnel (21), dont l'entrée non inverseuse (25) est connectée à la masse (M) ou à un autre potentiel de référence, dont l'entrée inverseuse (24) est connectée à l'électrode du capteur (6), et dont la sortie (23) est connectée à l'entrée inverseuse (24) comme moyen de compensation de la réponse en fréquence uniquement par l'intermédiaire d'une capacité (22).

4. Dispositif de protection contre les collisions (1) avec un capteur capacitif (2) selon l'une des revendications 1 à 3.
